(19) Europäisches Patentamt
European Patent Office
Office européen des brevets

(11) **EP 2 169 716 B1**

(12) **FASCICULE DE BREVET EUROPEEN**

(45) Date de publication et mention
de la délivrance du brevet:
**30.10.2013 Bulletin 2013/44**

(51) Int Cl.:
***H01L 21/98*** *(2006.01)*     ***H01L 21/78*** *(2006.01)*

(21) Numéro de dépôt: **09170962.6**

(22) Date de dépôt: **22.09.2009**

(54) **Procédé de report de puces sur un substrat**

Verfahren zur Übertragung von Chips auf einem Substrat

Method for transferring chips onto a substrate

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **24.09.2008 FR 0856421**

(43) Date de publication de la demande:
**31.03.2010 Bulletin 2010/13**

(73) Titulaire: **Commissariat à l'Énergie Atomique
et aux Énergies Alternatives
75015 Paris (FR)**

(72) Inventeurs:
• **Clavelier, Laurent
  38000, GRENOBLE (FR)**
• **Deguet, Chrystel
  38330, SAINT ISMIER (FR)**
• **Leduc, Patrick
  38000, GRENOBLE (FR)**
• **Moriceau, Hubert
  38120, SAINT-EGREVE (FR)**

(74) Mandataire: **Ilgart, Jean-Christophe et al
BREVALEX
95 rue d'Amsterdam
75378 Paris Cedex 8 (FR)**

(56) Documents cités:
DE-C1- 10 223 719    FR-A- 2 758 907
US-B1- 6 187 110    US-B1- 6 759 277

## Description

### DOMAINE TECHNIQUE ET ART ANTERIEUR

L'invention concerne le domaine de l'empilement des circuits semi-conducteurs et des techniques permettant de réaliser de tels empilements, notamment les techniques de reports de composants ou de puces en matériaux semi-conducteurs sur une plaque.

L'empilement de circuits est mis en oeuvre actuellement par deux types de techniques : les techniques de report de plaques à plaques et celles de report de puces sur des plaques.

Le report plaque à plaque est technologiquement plus simple mais se heurte à de sérieuses limitations :

- les puces des plaques à reporter doivent avoir la même taille, et il en résulte une contrainte très forte sur le design, interdisant quasiment l'achat de plaques chez plusieurs fournisseurs pour les assembler,
- le rendement des puces reportées rend rapidement cette technique rédhibitoire ; par exemple pour le cas de puces ayant un rendement de 85 % (filière mature), une opération de report de 5 plaques les unes sur les autres conduit à un rendement final de, seulement, 44 %.

La technique de report de puces sur une plaque est une autre solution, mais doit mettre en oeuvre des puces de plus en plus minces, ce qui pose d'autres problèmes. La tendance au report de puces de plus en plus fines s'explique par le souhait de :

- faciliter la réalisation des interconnexions ou vias traversants (dits « TSV »),
- augmenter la densité de ces vias (pour un rapport de forme donné, si on réduit leur profondeur, on réduit leur diamètre ce qui permet de réduire leur pas de répétition et donc d'augmenter leur densité),
- permettre un alignement à travers la puce amincie avec des équipements de lithographie standard,
- faciliter les opérations de replanarisation interpuces (il s'agit ici de l'étape consistant à refaire une surface plane après avoir reporté des puces sur une surface).

Or aujourd'hui les puces les plus fines que l'on peut traiter ont une épaisseur de l'ordre de 50 $\mu$m. Pour diminuer encore cette épaisseur, l'utilisation de poignées temporaires de report est nécessaire : on colle une poignée sacrificielle sur la face active du circuit à amincir, le rôle de cette poignée étant d'être un support mécanique de la plaque amincie (le plus souvent il s'agit d'une plaque de silicium). Après amincissement de la face passive du circuit à reporter, les puces sont découpées puis collées. Vient ensuite l'étape du retrait du morceau de poignée qui a assuré la rigidité de chaque puce.

Aujourd'hui il existe deux grandes techniques permettant un collage temporaire/démontage d'une poignée :

- le collage moléculaire ou direct, dit démontable, avec retrait mécanique de la poignée par insertion d'un séparateur (par exemple d'une lame). Son inconvénient majeur vient du fait qu'il faut décoller individuellement la poignée de chaque puce ; or, à titre d'exemple, si on reporte des puces de 1x1cm$^2$ à un pas de 1,5 cm sur une plaque de 300 mm de diamètre, il faut décoller individuellement environ 310 puces par plaque, ce qui est rédhibitoire,
- le collage de type « résine », avec un démontage de la poignée temporaire par traitement thermique, souvent assisté mécaniquement (cisaillement). Les difficultés résident à la fois dans l'action mécanique individuelle et dans la gestion des résidus de la résine de collage.

  De plus la technique utilisée pour amincir les plaques est le meulage ou « grinding » qui induit, dans le meilleur des cas, une variation d'épaisseur de +/- 1 $\mu$m pour des amincissements conduisant à des épaisseurs de puces amincies jusqu'à 5-10 $\mu$m, ce qui reste insuffisant. Or, une telle variation d'épaisseur nécessite notamment de surgraver les vias, ce qui en limite la densité et augmente le coût, et limite la réalisation et la précision des planarisations ultérieures.

  Il se pose donc le problème de trouver un nouveau procédé permettant un report de composants sur une plaque, en particulier en vue de réaliser un empilement d'étages de composants.

Le document US-A-6 187 110 décrit un procédé de fabrication de structures empilées comprenant la formation d'un premier substrat comprenant des composants.

L'implantation d'ions légers dans ce substrat, l'assemblage de ce substrat sur un second substrat suivi du clivage du premier substrat selon la zone implantée. Ce document ne décrit toutefois pas la fabrication de connexions.

### EXPOSÉ DE L'INVENTION

L'invention concerne donc un procédé de réalisation d'un empilement d'au moins deux étages de circuits, chaque étage comportant un substrat et au moins un composant, par exemple de type transistor, et des connexions métalliques formés dans ou sur ce substrat, l'assemblage d'un étage à reporter sur un étage précédent comportant :

  a) une implantation ionique dans le substrat de l'étage à reporter, à travers une surface de ce substrat, dite surface d'implantation et à travers au moins une partie des composants, de manière à former une zone de fragilisation sous les composants de ce substrat,

b) puis la formation, dans ce substrat, de connexions métalliques desdits composants entre eux et/ou en vue de connecter ces composants à d'autres composants, en particulier un ou des composants de l'étage précédent,

c) puis l'assemblage d'une partie de ce substrat, comportant des composants ou des groupes de composants, sa surface d'implantation étant assemblée sur et avec l'étage précédent,

d) puis une étape d'amincissement de la partie reportée dudit substrat, par fracture, par traitement thermique, au niveau de la zone de fragilisation.

Une implantation (étape a) avant réalisation des connexions métalliques (étape b) permet de contourner l'effet d'écran que formeraient celles-ci et également d'assurer une profondeur d'implantation suffisante. Elle permet d'obtenir une fracture ultérieure en minimisant le budget thermique à mettre en oeuvre pour obtenir cette fracture.

Selon l'invention, la formation d'une partie de composants a lieu avant l'étape d'implantation ; la réalisation des connexions métalliques a lieu après cette étape d'implantation. Enfin, il y a report de la couche comportant les composants sur l'étage précédent, et amincissement.

L'implantation peut être réalisée de manière uniforme dans tout le substrat, ou de manière masquée. Elle peut être réalisée à une profondeur comprise par exemple entre 1,5 $\mu$m et 2,5 $\mu$m sous la surface du substrat de l'étage à reporter.

L'étape c) est éventuellement précédée d'une étape de découpe du substrat, pour individualiser la partie de ce substrat à reporter et à assembler.

L'étape b) peut comporter la réalisation d'une succession de niveaux métalliques, par exemple 7, la réalisation de chacun de ces niveaux métalliques mettant en oeuvre un budget thermique dont la température est d'environ 400°C pour une durée d'environ 10 à 12 minutes (soit, au total, pour 7 niveaux métalliques, un budget total d'environ 400°C pendant 1h30mn), la fracture de l'étape d) étant réalisée avec un budget thermique dont la température est d'environ 450°C pour une durée d'environ 2h00. C'est notamment le cas pour un substrat en silicium et pour certaines conditions d'implantation d'hydrogène, dans une gamme de quelques $10^{16}$ à quelques $10^{17}$ ions/cm$^2$ et avantageusement entre $5.10^{16}$ et $10^{17}$ ions/cm$^2$ et préférentiellement entre $7.10^{16}$ ions/cm$^2$ et $9.10^{16}$ ions/cm$^2$) .

L'étape b) peut être réalisée avec un budget thermique permettant d'augmenter la fragilisation induite par implantation, et correspondant à environ 85 % ou 90 % du budget thermique total nécessaire pour obtenir la fracture le long de la zone de fragilisation.

Lors de l'étape c), c'est un collage entre deux couches de diélectriques SiO$_2$/SiO$_2$, ou oxyde/oxyde, ou un collage localement métal-métal (le métal n'est pas présent sur toute la surface mais en général seulement au niveau des plots de connexion) qui peut être mis en oeuvre.

Le ou les composants de l'étage à reporter, ainsi éventuellement que celui ou ceux de l'étage précédent, peuvent être un ou des transistor (s), ce sont par exemple des transistors CMOS.

L'étape a) d'implantation peut alors être réalisée après planarisation d'un diélectrique qui recouvre le substrat, mais avant lithographie des vias (ou « plugs ») des sources, des drains et des grilles des transistors.

L'empilement à réaliser peut comporter n étages, avec n≥2 ; on peut donc réitérer les étapes a)-d) jusqu'à obtention de cet empilement de n étages. Par exemple 5 ≤n ≤11, n=7 selon un exemple.

Dans ce cas, on pourra prévoir une étape de dépôt d'un diélectrique sur l'étage précédent et une étape de planarisation de ce diélectrique avant de réitérer le processus (par exemple directement après l'étape d) ou ultérieurement).

On pourra prévoir également avant de réitérer le processus la réalisation d'un ou plusieurs niveaux d'interconnexion sur l'étage précédent.

## BRÈVE DESCRIPTION DES DESSINS

- La figure 1 représente des étapes d'un procédé selon l'invention,
- les figures 2A - 2H sont des exemples de réalisation d'étapes d'un procédé selon l'invention,
- les figures 3A - 3C représentent des vues en coupe d'un transistor MOSFET, avant et après implantation,
- la figure 3D représente une vue de dessus qui permet de localiser les plans de coupes des figures 3A et 3B,
- les figures 4A et 4B représentent des courbes de bullage et de fracture en coordonnées 1/kT, ln(1/t),
- la figure 5 est un diagramme représentant l'évolution de la température et d'une fracture en fonction du temps dans un procédé selon l'invention.

## EXPOSÉ DÉTAILLÉ DE MODES DE RÉALISATION DE L'INVENTION

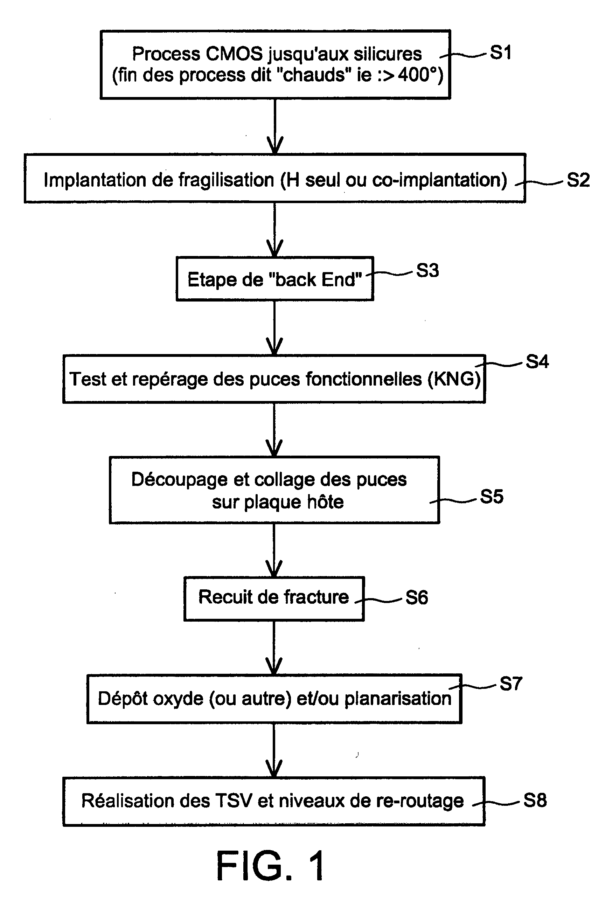

Des étapes d'un procédé selon l'invention sont représentées en figure 1.

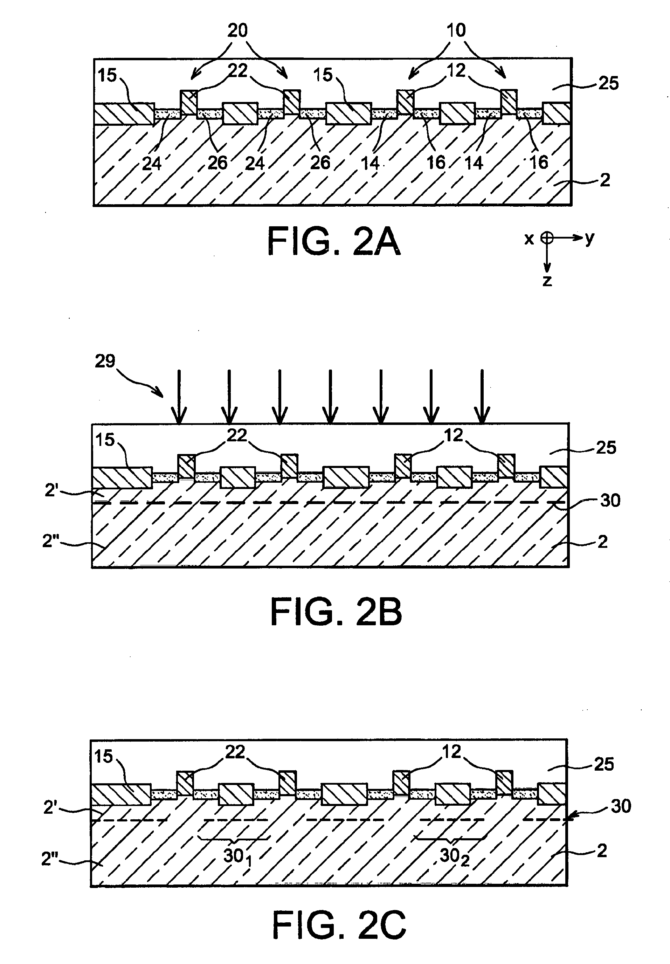

Chacune de ces étapes est représentée de manière plus détaillée dans le cadre d'un exemple simple, l'enchaînement des figures 2A - 2H. Cet exemple des figures 2A - 2H sera décrit en parallèle à la figure 1 et est volontairement simplifié pour faciliter la compréhension.

On se place ici dans le cadre de la réalisation de composants CMOS.

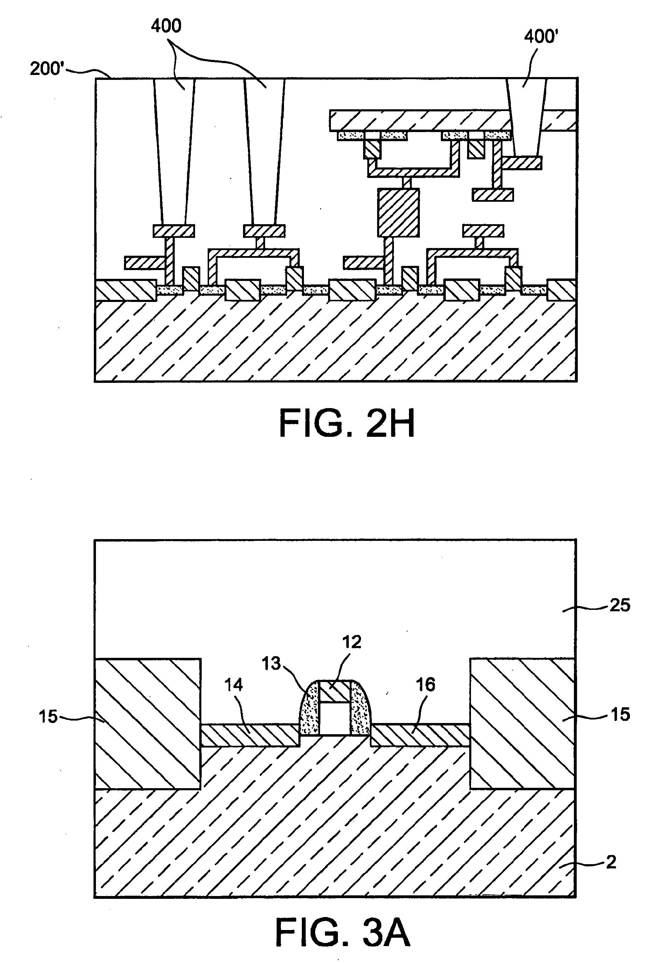

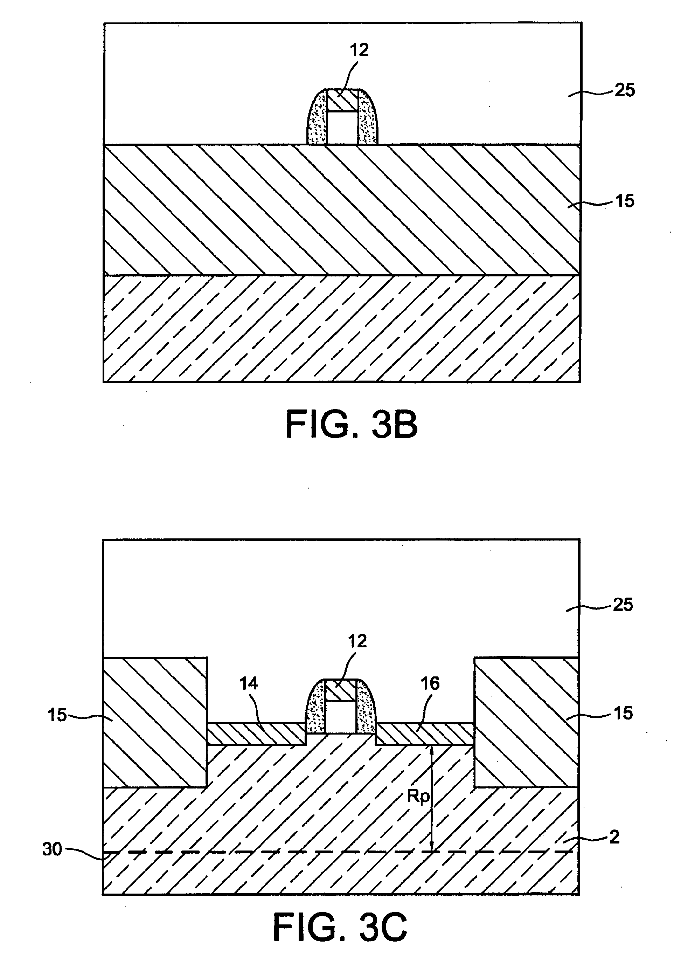

Dans une première étape (S1), on réalise, sur ou dans un substrat 2, en matériau semi-conducteur, par exemple en silicium, une pluralité de composants CMOS 10, 20, comportant chacun une grille 12, 22, un drain et une source réalisés par dopage et surmontés respectivement d'un siliciure de drain 14, 24 et d'un siliciure de source 16, 26 (figure 2A). Chacun de ces siliciures est par exemple un siliciure de Pt, ou de Pd, ou de Ni, ou de Co, ou de Ti, ... Sur la figure 2A sont également visibles les oxydes 15 d'isolation des transistors (oxyde STI). Un diélectrique 25 (dit PMD ou « Pre Metal Deposition ») est formé et planarisé sur cet ensemble. Une structure CMOS de ce type est décrite plus en détail en figures 3A, 3B.

En d'autres termes, la figure 2A représente en fait une plaque CMOS 2 dont les étapes « chaudes » (effectuées à une température supérieure à 400° C) sont terminées, après formation des siliciures de drains et de sources et le dépôt de couches 25 de planarisation. Le relief présent sur la plaque est alors essentiellement constitué d'un ensemble de grilles 12, 22, de drains 14, 24 et de sources 16, 26.

Après planarisation du diélectrique 25, mais avant lithographie des plots de contact des sources des drains et des grilles, on réalise une implantation d'espèces gazeuses 29 (figure 2B), par exemple d'hydrogène, prises seules ou en co-implantation (étape S2) avec d'autres espèces, comme l'hélium par exemple. On montre plus loin, en liaison avec les figures 3A - 3C, que les motifs ou éléments alors déjà formés sur ou dans la plaque ou le substrat 2 ne constituent pas un obstacle à l'obtention d'une implantation uniforme, dans cette plaque ou ce substrat et sous les motifs ou éléments ou composants 10, 20 déjà formés. L'implantation effectuée définit une zone 30 de fragilisation permettant, ensuite, de réaliser une fracture dans de bonnes conditions.

Pour une implantation dans un substrat de silicium, on pourra par exemple choisir d'implanter de l'hydrogène avec une dose comprise entre $10^{16}$ ions/cm² ou quelques $10^{16}$ et $10^{17}$ ions/cm² ou quelques $10^{17}$ ions/cm², par exemple $5.10^{17}$ ions/cm² et avantageusement entre $5.10^{16}$ ions/cm² et $10^{17}$ ions/cm² et préférentiellement entre $7.10^{16}$ ions/cm² et $9.10^{16}$ ions/cm². L'énergie d'implantation sera typiquement inférieure à 300KeV, par exemple comprise entre 30 et 200KeV.

Le résultat de cette implantation ou co-implantation est illustré en figure 2B par la formation d'une zone 30 de fragilisation. Cette zone est continue, en ce sens qu'elle s'étend sur toute la plaquette, l'implantation ayant été réalisée uniformément sur toute la plaquette. Cette zone sépare le substrat en deux parties, une partie 2" sous la zone de fragilisation 30, et une partie 2' entre cette zone de fragilisation 30 et les composants 10, 20 ....

En variante, il est possible de réaliser un niveau de masquage pour protéger des zones qui seraient sensibles à l'implantation d'Hydrogène, par exemple pour protéger les grilles 12, 22 des transistors MOSFET. On peut alors mettre en oeuvre la technique décrite dans le document FR 2 758 907. Le résultat de cette implantation ou co-implantation est illustré en figure 2C, sur laquelle on obtient des zones de fragilisation 30 disjointes, la distance entre deux zones de fragilisation voisines $30_1$, $30_2$ ne nuisant cependant pas à la qualité de la fracture réalisée ultérieurement.

Au cours de l'étape suivante (étape S3) on met en oeuvre des étapes de procédé, dites « back end », à basse température, par exemple inférieure à 400°C dans le cas d'un substrat de silicium : on réalise les plugs, c'est-à-dire les plots de contact des sources, des drains et des grilles. On réalise les plots, par exemple par lithographie et gravure puis par dépôt d'une couche électriquement conductrice, par exemple des dépôts successifs de Ti, TiN, W ou de Ta, TaN, W, conduisant à un empilement Ti/TiN/ ou Ta/TaN/W. On élimine ensuite la matière déposée en excès (par exemple par polissage mécano-chimique CMP et arrêt sur le diélectrique PMD 25).

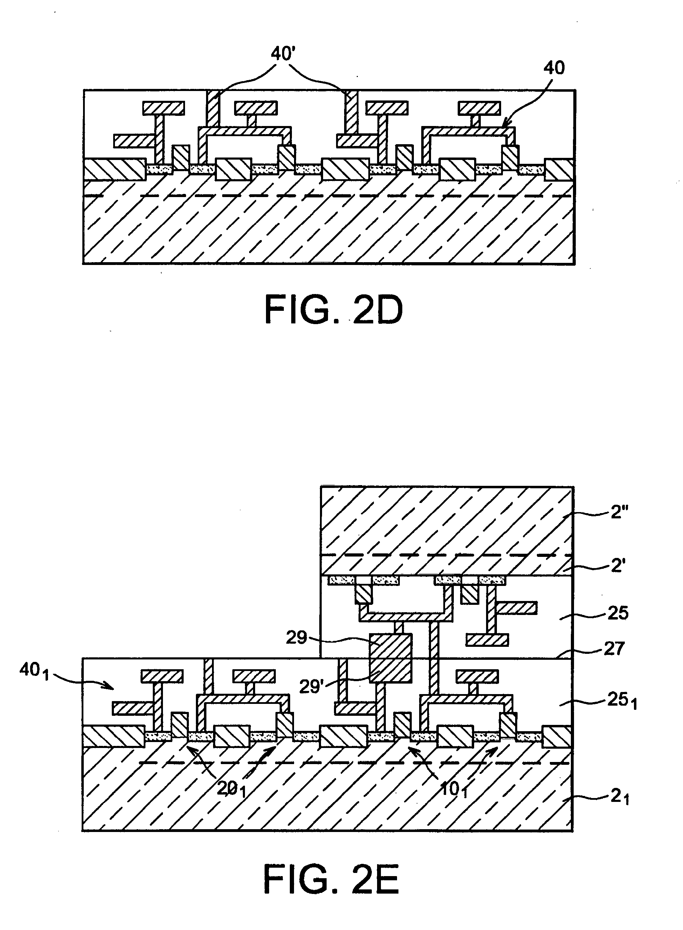

On réalise également des pistes horizontales (sensiblement parallèlement au plan xy du substrat) de connexions 40 en métal (par exemple en Al, ou AlCu, ou Cu)), par-dessus les éléments 12, 22, 14, 24, 16, 26 déjà formés (figure 2D). Des vias 40' (pistes verticales, sensiblement dirigées selon l'axe z, perpendiculaire au plan xy du substrat) sont également réalisés. Ces connexions métalliques permettent de connecter, entre eux ou, ultérieurement, à d'autres composants, les composants 10, 20 ou éléments déjà formés.

Les budgets thermiques alors mis en oeuvre sont suffisamment limités pour ne pas induire dans la zone fragilisée 30, $30_i$ de fracture, ni même de déformation en surface qui serait nuisible à la qualité d'un assemblage ultérieur.

Les puces ainsi réalisées peuvent alors être testées puis découpées (étape S4) : seules les puces fonctionnelles seront retenues pour l'étape ultérieure d'assemblage.

Chaque puce sélectionnée et découpée est ensuite assemblée, par exemple par collage, sur un substrat hôte (étape S5). Ce substrat hôte (l'étage précédent de l'empilement en cas de réitération du procédé) ne sera pas décrit en détail, mais il peut lui aussi comporter des composants $10_1$, $20_1$ sur un substrat $2_1$, et des connexions métalliques $40_1$ dans une couche de diélectrique $25_1$ (figure 2E). C'est en fait la face libre 25' du diélectrique 25, qui va être assemblée à la surface du substrat hôte, plus précisément à la couche de diélectrique $25_1$ de l'étage précédent, en cas de réitération du procédé. Dans le cas de la figure 2E, le collage a été réalisé entre les deux niveaux de diélectrique (de SiO2 par exemple) par exemple par collage moléculaire entre surfaces hydrophiles. Pour cela, les surfaces ont été, avant d'être mises en contact, préalablement préparées selon une ou plusieurs des techniques suivantes : nettoyage chimique, CMP, activation plasma, traitement UV Ozone.... La référence 27 désigne l'interface de collage.

En variante, si les surfaces des diélectriques 25, $25_1$ sont recouvertes par des films métalliques (par exemple de cuivre), un collage métal-métal (cuivre-cuivre dans l'exemple pris) peut aussi être réalisé. On pourra se référer à l'article de P.Gueguen et al intitulé « copper direct bonding for 3D integration », ICTC 08, 2008, IEEE International Interconnect Technology Conference IITC A. 2008, p.61-63, ISBN 9781424419111, pour la réalisation d'un tel collage. Sur la figure 2E, sont également représentées des zones 29, 29' de contact Cu/Cu de type plots de contacts (et non des vias). La surface de contact de chaque plot, dans le plan xy, est très supérieure à celle d'un via, ce qui permet d'assurer un meilleur contact.

Une variante sera également de faire adhérer des surfaces mixtes, composées de plusieurs matériaux (par exemples d'oxyde et de cuivre) ou de faire adhérer des surfaces présentant des topologies.

Le positionnement des puces sur le substrat hôte peut être réalisé par toute technique adaptée, par exemple des techniques dites de « Pick and Place » ou d'auto-alignement.

Le report des puces sur le substrat hôte peut être réalisé puce par puce ou par groupe de puces. La figure 2E illustre une puce assemblée sur un substrat hôte, résultant lui-même du procédé selon l'invention.

Une fois les puces disposés sur le substrat hôte, il est procédé à une étape de traitement thermique de fracture (étape S6), à basse température, qui va permettre de fracturer chaque puce le long de la zone fragilisée. Ce traitement thermique peut être assisté d'une sollicitation mécanique, l'insertion d'un séparateur par exemple ou toute autre technique susceptible d'accélérer la fracture.

On réalise de préférence cette opération de fracture dans des conditions de budget thermique indiquées ci-dessous.

La technique de fracture mise en oeuvre est connue sous le nom de Smart Cut™ et est décrite par exemple dans l'article de A.J. Auberton-Hervé et al. « Why can Smart-Cut change the future of microelectronics ? » paru dans International Journal of High Speed Electronics and Systems, Vol. 10, N°.1 (2000), p. 131-146.

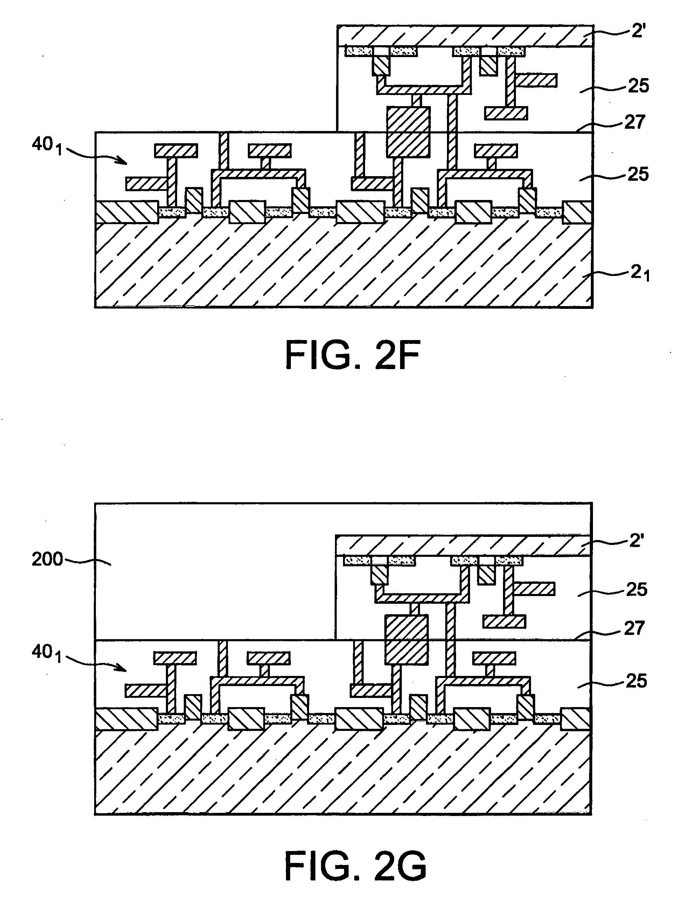

La figure 2F illustre l'état de la puce reportée, après fracture. La portion 2' du substrat initial 2 reste maintenue aux composants 10, 20.

On peut ensuite (étape S7) réaliser une étape de planarisation au niveau de la face libérée par la fracture. En complément ou en variante, on peut procéder au dépôt d'une couche 200, par exemple d'oxyde (figure 2G) que l'on vient ensuite éventuellement planariser pour former une nouvelle surface 200'.

Des vias 400, 400' peuvent ensuite être réalisés, pour venir établir des connexions entre la surface 200' et des composants du substrat hôte, sur lequel on vient d'effectuer un report, ou de la puce reportée ou de la portion de substrat reportée (figure 2H).

On peut également prévoir la réalisation d'un ou plusieurs niveaux de métaux notamment pour la réalisation de connexions complémentaires ou plus complexes.

Ces étapes peuvent être répétées autant de fois que nécessaire pour obtenir l'empilement souhaité : par exemple, on prend le substrat obtenu à l'issue de l'étape précédente (figure 2H) et on y effectue d'abord une opération de report de puces, comme sur la figure 2E, puis les autres étapes des figures 2F et suivantes, et notamment celle de fracture dans la zone fragilisée du substrat des puces en cours de report.

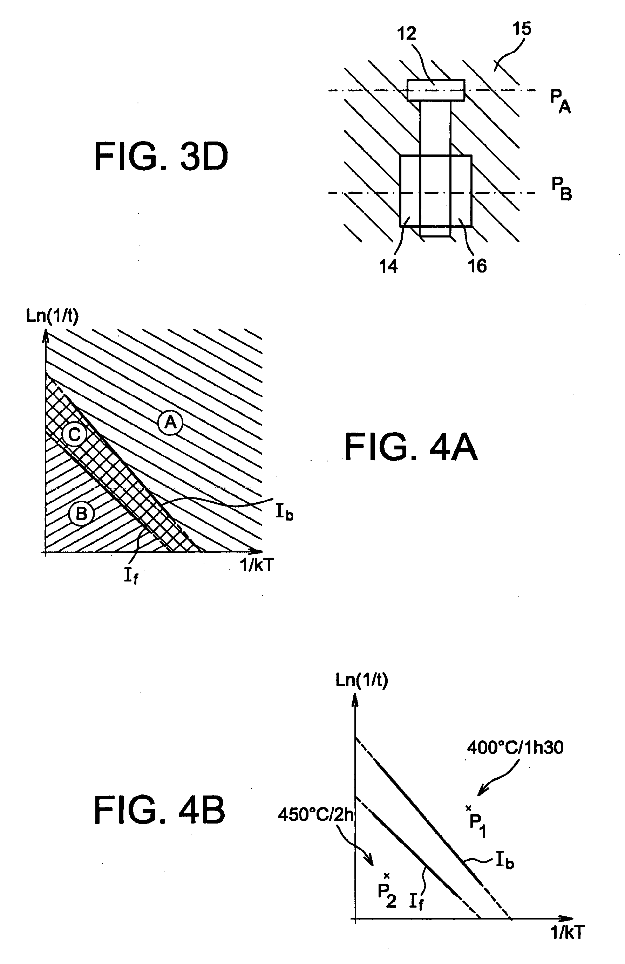

Les figures 3A et 3B représentent plus en détail une structure MOSFET avant l'étape d'implantation ionique décrite ci-dessus : la figure 3A est une coupe dans la zone active du MOSFET, tandis que la figure 3B est une coupe au niveau du plot de grille. La figure 3D représente une vue de dessus, sur laquelle sont indiqués les plans PA et PB de coupe des figures 3A et 3B.

On retrouve sur ces figures les mêmes références numériques que celles déjà utilisées ci-dessus. On voit de manière plus précise la source 16, le drain 14. La référence 15 désigne, là encore, l'oxyde d'isolation du transistor (oxyde STI). La référence 13 désigne les espaceurs, par exemple en $Si_3N_4$.

Typiquement, la couche 25 de diélectrique (PMD), par exemple en oxyde de silicium et/ou en PSG, a une épaisseur d'environ 400 nm, la grille 12, en polysilicium, a une épaisseur maximum d'environ 100 nm, et les siliciures de source et drain une épaisseur maximum d'environ 20 nm.

Il est apparu aux inventeurs que les composants ne forment pas d'écran notable lors de l'étape d'implantation et que malgré l'inhomogénéité des zones au travers desquelles l'implantation est réalisée, le profil d'implantation n'est pas significativement perturbé, ce qui ne remet pas en cause la fracture. Au contraire, un circuit CMOS fini, avec tous ses niveaux métalliques (5 à 11 aujourd'hui suivant la maturité des technologies, et couramment 7) ne permet pas de réaliser une implantation de fragilisation à travers les niveaux métalliques, compatible avec une fracture en dessous des MOSFET (typiquement au moins 200 nm en dessous de la surface). En effet, l'épaisseur cumulée des divers niveaux de métallisation est alors d'environ plusieurs $\mu$m, de sorte que les ions d'implantation (ici, de l'hydrogène mais le même problème se pose également pour tout autre élément) sont arrêtés avant d'avoir atteint le silicium du substrat 2 à un niveau inférieur à celui du MOSFET. Une fracture dans ce dernier est donc impossible.

Pour illustrer le pouvoir d'arrêt du cuivre à l'implantation d'hydrogène, les inventeurs ont réalisé une simulation atomistique de type Monte Carlo, connue sous le sigle SRIM, d'une implantation à très haute énergie (250 keV) dans du cuivre massif (ce qui correspond au comportement du cuivre des connexions de divers niveaux empilés) ; ils ont trouvé une valeur de Rp (profondeur d'implantation, ou « Range Project ») de l'ordre de

2 $\mu$m sous la surface du cuivre. Ainsi, si une implantation d'hydrogène est réalisée sur une plaque CMOS terminée, munie de tous ses niveaux de métallisation, soit plusieurs microns en cumulé, les ions hydrogènes sont arrêtés avant d'avoir atteint le silicium.

La figure 3C représente la même coupe que figure 3A, mais après formation de la zone fragilisée 30. Cette figure montre que l'absence de métal sur le trajet des ions permet de positionner le Rp suffisamment profondément, typiquement à une profondeur, sous la surface du substrat 2, pouvant atteindre un peu plus de 2 $\mu$m et proportionnelle à l'énergie d'implantation. L'implantation peut être réalisée à une profondeur comprise par exemple entre 1$\mu$m ou 1,5 $\mu$m et 2,5 $\mu$m ou 3 $\mu$m sous la surface du substrat 2 de l'étage à reporter.

En ce qui concerne le budget thermique total mis en oeuvre, les inventeurs ont pu mettre en évidence qu'il comprenait selon l'invention un premier budget thermique (dans la zone A de la figure 4A) correspondant au budget avant l'étape de collage, ce budget n'induisant aucune déformation de surface incompatible avec le collage (ce budget thermique est égal à n fois le budget thermique d'un niveau de métal, où n est le nombre de niveaux de métalliques) ; un second budget (dans la zone B de la figure 4A) correspondant au budget au terme duquel la fracture est induite à l'étape S6 dans le respect de l'intégrité des structures obtenues lors des étapes antérieures S1 à S5. La température du premier budget est sensiblement égale à 400°C pour une durée d'environ 1h30mn (pour 7 niveaux de métaux, ce qui est tout a fait admissible dans le cas d'empilements 3D de circuits); la température du second budget est sensiblement égale à 450°C pour une durée d'environ 2h (ce budget peut être adapté en fonction du budget thermique de collage si celui-ci n'est pas négligeable).

Cette plage de budget thermique permet de réaliser une fracture, dans des conditions admissibles par les matériaux utilisés, sans bullage préalable. Elle n'est pas limitée de manière stricte par les valeurs de températures et de durées indiquées.

Les figures 4A et 4B permettent de mieux comprendre en quoi la problématique posée est résolue.

Sur ces figures, les courbes $I_b$ et $I_f$ sont respectivement les courbes de bullage et de fracture d'un échantillon de substrat, comme représenté sur la figure 2C, préparé selon l'invention et implanté par des espèces gazeuses, comme par exemple de l'hydrogène. Le bullage (courbe Ib) correspond à une maturation importante des microcavités qui se développent dans la zone qui a été fragilisée par l'implantation. En l'absence d'un raidisseur suffisant à l'aplomb de ces cavités, la surface se déforme, cette déformation pouvant devenir incompatible avec un collage moléculaire ultérieur.

Lorsque le raidisseur (amené par le collage) est suffisamment efficace, ce mécanisme induit la fracture (courbe If).

Les phénomènes de bullage et/ou de fracture sont régis par des lois d'Arrhenius, du type :

$$1/t = A \times \exp(-Ea/kT),$$

avec :

-   t = temps de fracture ou bullage,
-   A = terme pré-exponentiel, homogène à l'inverse d'un temps,
-   Ea = Energie d'activation en eV,
-   k : constante de Boltzmann,
-   T : température absolue en K.

$E_a$ et A sont les paramètres de la loi d'Arrhenius de fracture, $E_a'$ et A' les paramètres de la loi d'Arrhenius de bullage.

Ces deux courbes sont donc des droites, représentées dans un plan en coordonnées (1/kT, ln(1/t)), où t représente la durée et T la température absolue en K.

Sur la figure 4A, ces deux droites séparent le plan dans lequel elles sont tracées en trois zones :

-   une zone A dite de « non bullage », qui correspond plutôt à des conditions de budget thermique relativement faibles, c'est-à-dire à des durées faibles et à des températures inférieures à ce qu'elles sont pour les deux autres zones,
-   une zone B dite de « fracture », qui correspond à des conditions de budget thermique relativement élevées, c'est-à-dire à des températures plus élevées que dans les autres zones, et pour des durées plutôt élevées,
-   et une zone C intermédiaire, entre les deux courbes, dans lequel le phénomène de bullage (maturation des cavités) se produit.

La courbe Ib est d'autant plus proche de la courbe If que la profondeur d'implantation (et donc l'énergie d'implantation) est importante.

Le budget thermique des étapes précédant le collage (étape S5) se situe dans la zone A afin d'éviter la fracture au niveau de la zone fragile et l'apparition d'une déformation de surface incompatible avec le collage.

Pour autoriser la fracture, le budget thermique de fracture se situe dans la zone B.

Afin de positionner les points (T, t) de budgets thermiques possibles dans le cadre de la présente invention, on a cherché à identifier le budget thermique d'un procédé de réalisation connu, en technologie 65 nm, d'un empilement comportant jusqu'à 7 niveaux de connexions métalliques.

Pour chacun de ces niveaux, la séquence technologique mise en oeuvre est sensiblement la suivante, avec, pour chaque étape, la mention du budget thermique avec la température et la durée :

-   dépôt de diélectrique : typiquement 0,4 $\mu$m de

SiOC ; budget thermique = 380°C - 4 min,

- recuit de libération des porogènes ; budget thermique = 400°C - 10 min,
- lithographie ligne/gravure partielle du diélectrique/ retrait résine ; aucun budget thermique,
- lithographie des vias et gravure partielle du diélectrique, puis retrait de la résine ; aucun budget thermique,
- dépôt barrière (typiquement TaN PVD) et cuivre ; aucun budget thermique,
- recuit du Cuivre ; budget thermique = 250°C - 2 min,
- polissage mécano-chimique du cuivre ; aucun budget thermique.

En cumulant l'ensemble de ces budgets thermiques, on peut estimer que le budget thermique équivalent d'un procédé selon l'invention, avec 7 niveaux de métaux, est d'environ (400°C, 1h30) = $(T_1, t_1)$ (pour chaque niveau de métal il est d'environ 400°C pour 10 à 12 minutes). Ce budget thermique ne doit pas induire de déformation de surface qui soit incompatible avec un collage direct. Le point $P_1$ sur la figure 4B correspond à un budget thermique possible pour ces étapes.

Le budget thermique maximal admissible est imposé par la structure elle-même. On note en particulier que la température de formation d'un siliciure de nickel stable est d'environ 450°C. Ce siliciure est stable pendant 1/2h à environ 550°C. Moyennant une implantation de fluor et l'adjonction d'un faible pourcentage de platine, la stabilité de ce siliciure est portée à 650°C pendant 1/2h.

Par ailleurs, le budget thermique maximal admissible pour des porogènes (diélectriques de type SiOC) est quant à lui autour de (450°C, 2h).

Un budget thermique maximum de (450°C, 2 h) est à respecter. Le point $P_2$ de la figure 4B correspond à un tel budget.

Le point de fonctionnement d'un procédé selon l'invention répond de préférence aux critères suivants (les notations sont celles déjà introduites ci-dessus) :

- au point $P_1$, $1/t_1 > A'$ x exp $(-E_a'/kT_1)$ : condition de maturation des cavités sans induire de bullage néfaste au collage ultérieur, pendant la formation des connexions métalliques 40 (figure 2D),
- au point $P_2$, $1/t_2 < A$ x exp $(-E_a/kT_2)$ : condition de fracture avec un budget thermique admissible par les connexions métalliques 40 de la puce et respectueux des étapes S1 à S5.

Les conditions $(T_{|1}, t_1)$, $(T_2, t_2)$ de température et de durée posées ci-dessus satisfont à ces inégalités : ainsi, on voit sur la figure 4B que le budget thermique $(T_1, t_1)$ et le budget thermique $(T_2, t_2)$, correspondent à l'enchainement d'une étape de traitement, sans fracture, ni bullage qui serait incompatible avec le collage, et d'une étape de fracture.

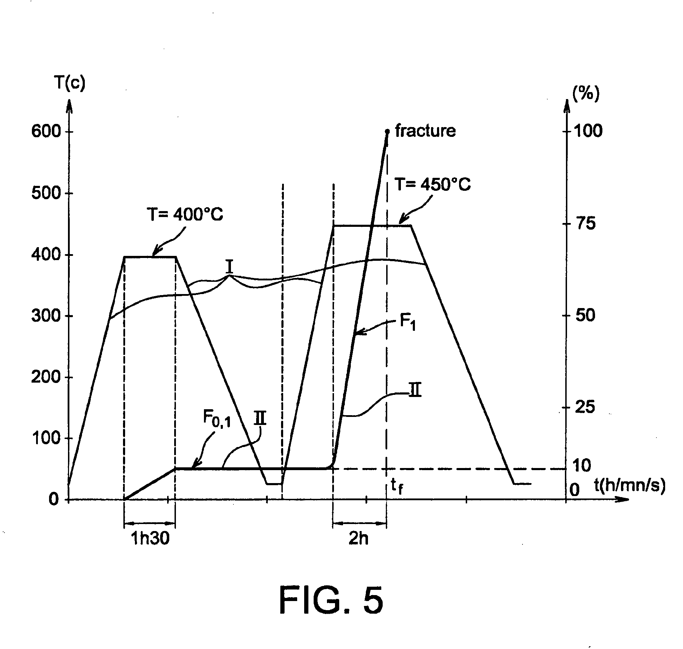

Un exemple de mise en oeuvre de l'invention va être donné, cet exemple est illustré en figure 5, qui représente l'évolution de la température (courbe I, échelle verticale de gauche) en fonction du temps, et d'autre part le pourcentage de fragilisation, en % (courbe II, échelle verticale de droite) également en fonction du temps.

Partant d'une structure telle que celle de la figure 2A, on procède d'abord (figure 2B) à une implantation d'hydrogène à une énergie de 210KeV, avec une dose de $8.10^{16}$ ions/cm$^2$.

Le traitement thermique des niveaux métalliques (étape de la figure 2D) est réalisé avec des budgets thermiques équivalents à un budget thermique de 400°C - 1h30mn, comme indiqué sur la figure 5. Ce traitement thermique entraîne une fragilisation de l'ordre de 10 % comme la ligne horizontale $F_{0,1}$ de la figure 5 l'indique. Ce budget thermique correspond à 10 % du budget thermique qui est nécessaire pour obtenir la fracture ; par exemple 10 % du temps qui serait nécessaire à cette température pour obtenir la fracture à cette température si le collage était entre temps réalisé. Une telle fragilisation ne provoque pas de bullage compte tenu de l'énergie d'implantation (i.e. de la profondeur de la zone fragilisée 30). Elle reste donc compatible avec le procédé selon l'invention, et notamment avec un collage direct (moléculaire) ultérieur (étape de la figure 2E).

Un traitement thermique supplémentaire, après collage, avec un budget thermique de l'ordre de (450°C, 1h30) induit une fracture. Ce budget thermique est compatible avec les traitements thermiques admissibles par une structure CMOS comportant des niveaux métalliques. Ce deuxième traitement thermique entraîne une rupture complète au niveau de la zone de fragilisation comme la droite $F_1$ de la figure 5 l'indique, puisque le point de fragilisation à 100% est atteint après 1h30 à 450°C.

La température est ensuite ramenée à sa valeur ambiante.

**Revendications**

1. Procédé de réalisation d'un empilement d'au moins deux étages de circuits, chaque étage comportant un substrat et au moins un composant (10, 20) et des connexions métalliques (40) formés dans ou sur ce substrat, l'assemblage d'un étage à reporter sur un étage précédent $(2_1, 25_1)$ comportant :

  a) une implantation ionique (29) dans le substrat (2, 25) de l'étage à reporter, à travers une surface (25') de ce substrat, dite surface d'implantation et à travers au moins une partie des composants (10, 20), de manière à former une zone de fragilisation (30, $30_i$) sous les composants de ce substrat,
  b) puis la formation, dans ce substrat, de connexions métalliques (40) desdits composants entre eux et/ou en vue de connecter ces composants à d'autres composants,

c) puis le report et l'assemblage d'une partie de ce substrat, comportant des composants ou des groupes de composants, par sa surface (25') d'implantation, sur l'étage précédent ($2_1$, $25_1$),

d) puis une étape d'amincissement de la partie reportée dudit substrat, par fracture le long de la zone de fragilisation (30, $30_i$).

2. Procédé selon la revendication 1, l'implantation étant réalisée de manière uniforme dans tout le substrat, ou étant réalisée de manière masquée.

3. Procédé selon l'une des revendications 1 ou 2, l'étape c) étant précédée d'une étape de découpe du substrat, pour individualiser la partie de ce substrat à reporter et à assembler.

4. Procédé selon l'une des revendications 1 à 3, le substrat étant en silicium, l'implantation étant une implantation d'hydrogène, avec une dose comprise entre $10^{16}$ ions/cm$^2$ et $5.10^{17}$ ions/cm$^2$.

5. Procédé selon la revendication 4, l'implantation étant une implantation d'hydrogène, avec une dose comprise entre $5.10^{16}$ ions/cm$^2$ et $10^{17}$ ions/cm$^2$ ou entre $7.10^{16}$ ions/cm$^2$ et $9.10^{16}$ ions/cm$^2$.

6. Procédé selon l'une des revendications 1 à 5, l'étape b) étant réalisée avec un budget thermique dont la température est d'environ 400°C pour une durée d'environ 1h30mn, la fracture de l'étape d) étant réalisée avec un budget thermique dont la température est d'environ 450°C pour une durée d'environ 2h00.

7. Procédé selon l'une des revendications 1 à 6, l'étape b) étant réalisée à une température permettant une fracture partielle le long de la zone de fragilisation (30, $30_i$).

8. Procédé selon l'une des revendications 1 à 7, l'étape c) comportant un collage entre deux couches (25, $25_1$) de diélectriques SiO$_2$/SiO$_2$, ou oxyde/oxyde, ou, localement, un collage métal-métal.

9. Procédé selon l'une des revendications 1 à 8, les composants de l'étage à reporter étant des transistors CMO5, l'étape a) d'implantation étant réalisée après planarisation d'un diélectrique (25) qui recouvre le substrat, mais avant lithographie de plots de contact des sources (16, 26), des drains (14, 24) et des grilles (12, 22) des transistors.

10. Procédé selon l'une des revendications 1 à 9, dans lequel l'empilement à réaliser comporte n étages, $n \geq 2$, et dans lequel on réitère les étapes a)-d) jusqu'à obtention de cet empilement de n étages.

11. Procédé selon la revendication 10, dans lequel on réalise une étape de planarisation avant de réitérer les étapes a)-d).

12. Procédé selon l'une des revendications 10 ou 11, dans lequel on réalise un ou plusieurs niveaux d'interconnexion sur l'étage précédent avant de réitérer les étapes a)-d).

## Patentansprüche

1. Verfahren zur Herstellung eines Stapels von wenigstens zwei Schaltungsstufen, wobei jede Stufe ein Substrat und wenigstens eine Komponente (10, 20) und metallische Verbindungen (40) umfasst, ausgebildet in oder auf dem Substrat, wobei das Zusammenbauen einer zu übertragenden Stufe mit einer vorhergehenden Stufe ($2_1$, $25_1$) umfasst :

   a) eine Ionenimplantation (29) in dem Substrat (2, 25) der zu übertragenden Stufe durch eine Implantationsoberfläche genannte Fläche bzw. Oberseite (25') dieses Substrats und durch wenigstens einen Teil der Komponenten (10, 20) hindurch, um unter den Komponenten dieses Substrats eine Schwächungszone (30, $30_i$) zu bilden,

   b) dann, in diesem Substrat, die Ausbildung metallischer Verbindungen (40) der genannten Komponenten miteinander und/oder hinsichtlich der Verbindung dieser Komponenten mit anderen Komponenten,

   c) dann das Übertragen eines Komponenten oder Gruppen von Komponenten umfassenden Teils dieses Substrats auf die vorhergehende Stufe ($2_1$, $25_1$) und das Zusammenbauen mittels seiner Implantationsoberfläche (25'),

   d) dann einen Schritt zur Verdünnung des auf das genannte Substrat übertragenen Teils durch Brechen längs der Schwächungszone (30, $30_i$).

2. Verfahren nach Anspruch 1, wobei die Implantation gleichmäßig in dem gesamten Substrat erfolgt, oder auf maskierte Weise erfolgt.

3. Verfahren nach einem der Ansprüche 1 oder 2, wobei dem Schritt c) ein Substrat-Schneideschritt vorausgeht, um den für das Übertragen und das Zusammenbauen bestimmten Teil dieses Substrats zu vereinzeln.

4. Verfahren nach einem der Ansprüche 1 bis 3, wobei das Substrat aus Silicium ist und die Implantation eine Wasserstoffimplantation ist, mit einer zwischen $10^{16}$ und $5.10^{17}$ Ionen/cm$^2$ enthaltenen Dosis.

**5.** Verfahren nach Anspruch 4, wobei die Implantation eine Wasserstoffimplantation ist, mit einer zwischen $5.10^{16}$ Ionen/cm$^2$ und $10^{17}$ Ionen/cm$^2$ oder zwischen $7.10^{16}$ Ionen/cm$^2$ und $9.10^{16}$ Ionen/cm$^2$ enthaltenen Dosis.

**6.** Verfahren nach einem der Ansprüche 1 bis 5, wobei der Schritt b) mit einem Wärmebudget realisiert wird, dessen Temperatur ungefähr 400 °C für eine Dauer von ungefähr 1 h30min beträgt, wobei der Bruch des Schritts d) mit einem Wärmebudget realisiert wird, dessen Temperatur ungefähr 450 °C für eine Dauer von ungefähr 2h00 beträgt.

**7.** Verfahren nach einem der Ansprüche 1 bis 6, wobei der Schritt b) mit einer Temperatur realisiert wird, die einen partiellen Bruch längs der Schwächungszone $(30, 30_i)$ ermöglicht.

**8.** Verfahren nach einem der Ansprüche 1 bis 7, wobei der Schritt c) eine Klebung zwischen zwei Dielektrika- oder Oxid/Oxid-Schichten $(25, 25_i)$ oder, lokal, eine Metall-Metall-Klebung umfasst.

**9.** Verfahren nach einem der Ansprüche 1 bis 8, wobei die Komponenten der zu übertragenden Stufe CMOS-Transistoren sind und der Implantationsschritt a) nach dem Planarisieren eines das Substrat bedeckenden Dielektrikums (25) aber vor dem Lithographieren der Kontaktplättchen der Sources (16, 26), Drains (14, 24) und Gates (12, 22) der Transistoren realisiert wird.

**10.** Verfahren nach einem der Ansprüche 1 bis 9, bei dem der zu realisierende Stapel n Stufen, $n \geq 2$, umfasst, und bei dem man die Schritte a) - d) wiederholt, bis dieser Stapel von n Stufen hergestellt ist.

**11.** Verfahren nach Anspruch 10, bei dem man einen Planarisierungsschritt durchführt, bevor man die Schritte a) - d) wiederholt.

**12.** Verfahren nach einem der Ansprüche 10 oder 11, bei dem man vor Wiederholung der Schritte a) - d) auf der vorhergehenden Stufe eine oder mehrere Verbindungs- bzw. Zusammenschaltungsebenen realisiert.

**Claims**

**1.** Method for making a stack of at least two stages of circuits, each stage comprising a substrate and at least one component (10, 20) and metallic connections (40) formed in or on this substrate, the assembly of a stage to be transferred onto a previous stage $(2_1, 25_1)$ comprising:

a) ionic implantation (29) in the substrate (2, 25) of the stage to be transferred through a surface (25') of this substrate, said implantation surface and through at least part of the components (10, 20), so as to form a weakened zone $(30, 30_i)$ under the components of this substrate,
b) then formation of metallic connections (40) of said components in this substrate between each other and/or in order to connect these components to other components,
c) then transfer and assembly of part of this substrate, comprising components or groups of components, through its implantation surface (25') onto the previous stage $(2_1, 25_1)$,
d) then a step to thin the transferred part of said substrate by fracture along the weakened zone $(30, 30_i)$.

**2.** Method according to claim 1, the implantation being done uniformly throughout the substrate, or being done in a masked manner.

**3.** Method according to one of claims 1 or 2, step c) being preceded by a substrate cutting step to individualise the part of this substrate to be transferred and assembled.

**4.** Method according to one of claims 1 to 3, the substrate being made of silicon, the implantation being a hydrogen implantation, within a range of between $10^{16}$ ions/cm$^2$ and $5 \times 10^{17}$ ions/cm$^2$.

**5.** Method according to claim 4, the implantation being a hydrogen implantation, within a range of between $5 \times 10^{16}$ ions/cm$^2$ and $10^{17}$ ions/cm$^2$ or between $7 \times 10^{16}$ ions/cm$^2$ and $9 \times 10^{16}$ ions/cm$^2$.

**6.** Method according to one of claims 1 to 5, step b) being done with a thermal budget for which the temperature is equal to approximately 400°C for a duration of about 1h30min, the fracture in step d) being done with a thermal budget for which the temperature is equal to approximately 450°C for a duration of about 2h00.

**7.** Method according to one of claims 1 to 6, step b) being done at a temperature enabling partial fracture along the weakened zone $(30, 30_i)$.

**8.** Method according to one of claims 1 to 7, step c) comprising bonding between two $SiO_2/SiO_2$ or oxide/oxide dielectric layers $(25, 25_1)$, or local metal-metal bonding.

**9.** Method according to one of claims 1 to 8, the components in the stage to be transferred being CMOS transistors, the implantation step a) being done after planarising a dielectric (25) that covers the substrate but before lithography of the contact pads of the transistor sources (16, 26), drains (14, 24) and gates (12, 22).

10. Method according to one of claims 1 to 9 in which the stack to be made comprises n stages, n≥2, and in which steps a)-d) are reiterated until this stack of n stages is obtained.

11. Method according to claim 10, in which a planarising step is carried out before reiterating steps a) -d).

12. Method according to one of claims 10 or 11, in which one or several interconnection levels are made on the previous stage before reiterating steps a) -d).

Process CMOS jusqu'aux silicures
(fin des process dit "chauds" ie :> 400°) — S1

↓

Implantation de fragilisation (H seul ou co-implantation) — S2

↓

Etape de "back End" — S3

↓

Test et repérage des puces fonctionnelles (KNG) — S4

↓

Découpage et collage des puces
sur plaque hôte — S5

↓

Recuit de fracture — S6

↓

Dépôt oxyde (ou autre) et/ou planarisation — S7

↓

Réalisation des TSV et niveaux de re-routage — S8

# FIG. 1

FIG. 2A

FIG. 2B

FIG. 2C

FIG. 2D

FIG. 2E

**FIG. 2F**

**FIG. 2G**

FIG. 2H

FIG. 3A

FIG. 3B

FIG. 3C

## FIG. 3D

## FIG. 4A

## FIG. 4B

FIG. 5

## RÉFÉRENCES CITÉES DANS LA DESCRIPTION

**Documents brevets cités dans la description**

- US 6187110 A

- FR 2758907

**Littérature non-brevet citée dans la description**

- **P.GUEGUEN et al.** copper direct bonding for 3D integration. *ICTC 08, 2008, IEEE International Interconnect Technology Conference IITC A.,* 2008, ISBN 9781424419111, 61-63

- **A.J. AUBERTON-HERVÉ et al.** Why can Smart-Cut change the future of microelectronics ?. *International Journal of High Speed Electronics and Systems,* 2000, vol. 10 (1), 131-146